# EUROPÄISCHE PATENTSCHRIFT

(11) **EP 3 682 474 B1**
(45) Veröffentlichungstag und Bekanntmachung des Hinweises auf die Patenterteilung: **05.01.2022**
(21) Anmeldenummer: 18769131.6
(22) Anmeldetag: 07.09.2018
(51) Int. Cl.: H01L 23/373, H01S 5/024

(54) **VERBUND AUS MEHREREN ADAPTERELEMENTEN UND VERFAHREN ZUR HERSTELLUNG EINES SOLCHEN VERBUNDS**
ARRANGEMENT OF SEVERAL ADAPTER ELEMENTS AND METHOD FOR PRODUCING SUCH A COMPOSITE
ARRANGEMENT DE PLUSIEURS ELEMENTS D'ADAPTATEUR ET PROCEDE DE PRODUCTION D'UN TEL COMPOSITE

(30) Priorität: 12.09.2017 DE 102017121015
(43) Veröffentlichungstag der Anmeldung: 22.07.2020
(73) Patentinhaber: Rogers Germany GmbH, 92676 Eschenbach (DE)
(72) Erfinder: WIESEND, Johannes, 92676 Speinshart (DE); SCHWEIGER, Heiko, 95519 Oberbibrach (DE)
(74) Vertreter: Müller Schupfner & Partner Patent- und Rechtsanwaltspartnerschaft mbB
(86) Internationale Anmeldenummer: PCT/EP2018/074207
(87) Internationale Veröffentlichungsnummer: WO 2019/052924

(56) Entgegenhaltungen:
- DE-A1-102005 061 049
- DE-A1-102006 009 159
- US-A1- 2003 104 678
- US-A1- 2003 211 708
- US-A1- 2012 161 190
- US-A1- 2015 108 518

## Beschreibung

Die vorliegende Erfindung betrifft einen Verbund aus mehreren Adapterelementen und ein Verfahren zur Herstellung eines solchen Verbunds.

Zur Kühlung von im Betrieb wärmeentwickelnden, elektrischen Bauelementen wie Laserdioden kennt der Stand der Technik Kühlkörper, die mit der Laserdiode über ein Adapterelement verbunden sind. Ein Beispiel hierfür ist in der JP 2004 186 527 A zu finden. Die zwischen der Laserdiode und dem Kühlkörper angeordneten Adapterelemente dienen dabei üblicherweise der Anpassung von unterschiedlichen Ausdehnungskoeffizienten der Materialien, aus denen die Kühlkörper und die elektrischen Bauelements wie OP-Verstärker, Spulen oder Laserdiode gefertigt sind. Hintergrund hierzu ist, dass andernfalls die unterschiedlichen Ausdehnungskoeffizienten im Betrieb zu thermomechanisch induzierten Spannungen im Anbindungsbereich führen können. Folge dieser thermomechanischen Spannungen kann eine Deformation der Laserdiode, die wiederum zu einer Änderung der Emissionswellenlänge der Laserdiode führen kann, oder sogar eine Rissbildung sein.

Zur Herstellung der Verbindung zwischen dem Kühlkörper und der Laserdiode wird daher die Laserdiode über das Adapterelement mit dem Kühlkörper gefügt, insbesondere verlötet unter der Verwendung von AuSn-Lotmaterial. Hierzu müssen die Adapterelemente mit dem AuSn-Lotmaterial beschichtet werden, typischerweise unter Verwendung eines Sputterverfahrens.

Außerdem ist aus der DE 10 2006 009 159 A1 ein Verbundsubstrat mit einem Träger bekannt, der zumindest an wenigstens einer Oberflächenseite aus einem metallischen Material, beispielsweise aus Kupfer und/oder Aluminium besteht.

In der US 2003 21 1 708 ist ein Verfahren zur Herstellung eines Halbleiterbauelements beschrieben, das die folgenden Schritte umfasst:
a) Bereitstellen eines Kühlelements mit einem elektrisch isolierenden, plattenförmigen Träger mit einer ersten Hauptfläche und einer zweiten Hauptfläche, wobei die erste Hauptfläche mit einer Metallschicht bedeckt ist,
b) Strukturieren der Metallschicht in eine Mehrzahl von metallischen Flächen derart, dass die metallischen Flächen eine Montageplattform für eine Mehrzahl von Halbleiterlaserdioden bilden,
c) Aufbringen einer Mehrzahl von Laserdioden-Halbleiterkörpern und einer Mehrzahl von optischen Elementen, die den Laserdioden-Halbleiterkörpern zugeordnet sind, wobei jeweils ein Laserdioden-Halbleiterkörper auf einer metallischen Fläche angeordnet ist, und
d) Zerteilen des Kühlelements in die Mehrzahl von Halbleiterlaserbauelementen hergestellt ist.

In der DE 10 2005 061 049 A1 ist ein Metall-Keramik-Substrat vorgesehen mit wenigstens einer durch Ätzen strukturierten Metallisierung auf zumindest einer Oberflächenseite eines plattenförmigen Keramikmaterials, welches aus einem Basissubstrat aus einer Aluminiumnitrid- oder Siliziumnitrid-Keramik besteht und auf welches die Metallisierung vor dem Strukturieren durch Aktivlöten aufgebracht ist.

Basierend auf diesem Hintergrund macht es sich die vorliegende Erfindung zur Aufgabe, Adapterelemente bereitzustellen, die im Betrieb hohen Temperaturbelastungen standhalten, eine optimale Anpassung der Ausdehnungskoeffizienten im System aus Bauelement wie Laserdiode, Adapterelement und Kühlkörper erlauben und sich vergleichsweise einfach und schnell herstellen lassen.

Diese Aufgabe wird gelöst durch ein Verbund aus mehreren Adapterelementen gemäß Anspruch 1 und ein Verfahren zur Herstellung eines Verbunds gemäß Anspruch 9. Weitere Vorteile und Merkmale der Erfindung ergeben sich aus den Unteransprüchen sowie der Beschreibung und den beigefügten Figuren.

Erfindungsgemäß ist ein Verbund aus mehreren Adapterelement vorgesehen, die zum Anbinden eines Bauelements wie einer Laserdiode an einen Kühlkörper geeignet sind, vorgesehen, umfassend:
-- eine erste Metallschicht, die im montierten Zustand dem Bauelement zugewandt ist, und eine zweite Metallschicht, die im montierten Zustand dem Kühlkörper zugewandt ist, und weiter gekennzeichnet durch
-- eine zwischen der ersten Metallschicht und der zweiten Metallschicht angeordnete, Keramik umfassende Zwischenschicht,
wobei die ersten Metallschicht und/oder die zweite Metallschicht dicker als 40 µm, bevorzugt dicker als 70 µm und besonders bevorzugt dicker als 100 µm ist, wobei die Adapterelemente durch eine Sollbruchstelle von einem Träger trennbar sind, und die Adapterelemente einen elektrisch leitenden Kontakt zum Träger des Verbunds aufweisen.

Gegenüber dem Stand der Technik ist erfindungsgemäß eine vergleichsweise dicke erste und/oder zweite Metallschicht vorgesehen, deren Dicke mit Vorteil eine Wärmeaufspreizung beim Wärmetransport durch das Adapterelement unterstützt. Diese Wärmeaufspreizung führt wiederum zu einer möglichst homogenen Wärmeverteilung in einem Schnittstellenbereich zwischen dem Kühlkörper und dem Adapterelement. Dadurch lassen sich mit Vorteil thermomechanische Spannungen entgegenwirken, die durch unterschiedliche thermische Ausdehnungskoeffizienten der einzelnen Bauteile bedingt werden. D. h. es lässt sich ein Adapterelement bereitstellen, mit dem sich eine spannungsreduzierte Schnittstelle zwischen Adapterelement und Kühlkörper im montierten Zustand realisieren lässt, wodurch in vorteilhafter Weise eine Rissbildung im System aus z. B. Laserdiode, Adapterelement und Kühlkörper bzw. eine z. B. die Wellenlänge ändernde Deformation der Laserdiode unterdrückt werden kann. Zudem lässt sich die anspruchsgemäße Dicke der ersten Metallschicht und/oder der zweiten Metallschicht in vorteilhafter Weise mittels eines DCB-Verfahrens oder eines Aktivlot-Verfahrens einfach und schnell realisieren. Ferner erlaubt die Verwendung einer die Keramik aufweisenden Zwischenschicht die Anpassung der thermischen Ausdehnungskoeffizienten, wodurch der Ausprägung von thermomechanischen Spannungen im Betrieb weiter entgegengewirkt werden kann.

Vorzugsweise umfasst die erste Metallschicht und/oder die zweite Metallschicht Kupfer, insbesondere mit einem Reinheitsgrad von 99,98 % oder höher. Weiterhin ist es vorgesehen, dass die Zwischenschicht Al₂O₃, Si₃N₄, oder eine HPSX-Keramik (d. h. eine Keramik mit einer Al₂O₃-Matrix, die einen x-prozentigen Anteil an ZrO₂ umfasst, beispielsweise Al₂O₃ mit 9 % ZrO₂ = HPS9 oder Al₂O₃ mit 25 % ZrO₂ = HPS25) aufweist. Besonders bevorzugt ist es vorgesehen, wenn es sich um eine AIN umfassende Keramik handelt, insbesondere mit einer Wärmeleitfähigkeit von mehr als 150 W/mK, bevorzugt mehr als 175 W/mK und besonderes bevorzugt von mehr als 225 W/mK. Dadurch lässt sich mit Vorteil die Anpassung an die Ausdehnungskoeffizienten weiter verbessern.

Gemäß einer weiteren Ausführungsform der vorliegenden Erfindung ist es vorgesehen, dass die Zwischenschicht zur Anpassung der Ausdehnungskoeffizienten dünner als 400 µm, bevorzugt dünner als 200 µm und besonders bevorzugt dünner als 100 µm ist. Insbesondere ist es vorgesehen, dass die Zwischenschicht eine Sekundärdicke aufweist, die zur möglichst optimalen Anpassung der Ausdehnungskoeffizienten ausgelegt ist. Dadurch lässt sich eine Unterdrückung von thermomechanischen Spannungen weiter unterstützen. Vorzugsweise nimmt ein Verhältnis zwischen einer aufsummierten Dicke einer Primärschichtdicke der ersten Metallschicht und einer Primärschichtdicke der zweiten Metallschicht zur Sekundärschichtdicke der Zwischenschicht einen Wert zwischen 0,7 und 2, bevorzugt zwischen 0,8 und 1,5 und besonders bevorzugt zwischen 0,95 und 1,2 an.

Vorzugsweise nimmt die Sekundärschicht eine Dicke zwischen 0,05 mm und 0,5 mm, bevorzugt zwischen 0,1 mm und 0,4 mm und besonders bevorzugt zwischen 0,2 und 0,38 mm an. Ferner sind als Primärschichtdicke der einzelnen ersten Metallschicht bzw. der zweiten Metallschicht Werte zwischen 0,01 mm und 0,15 mm, bevorzugt zwischen 0,02 und 0,13 mm und besonders bevorzugt zwischen 0,025 und 0,11 mm vorstellbar. Insbesondere nimmt ein Verhältnis der aufsummierten Primärschichtdicke der ersten und der zweiten Metallschicht zur Sekundärschichtdicke der Zwischenschicht einen Wert zwischen 0,2 und 0,8, bevorzugt zwischen 0,25 und 0,65 und besonders bevorzugt zwischen 0,3 und 0,55 an. Vorzugsweise ist es vorgesehen, dass das Adapterelement zu mindestens 20 % aus der ersten Metallschicht und der zweiten Metallschicht gebildet ist.

In einer weiteren Ausführungsform der vorliegenden Erfindung ist es vorgesehen, dass mehrere Adapterelemente in einem Verbund bereitgestellt sind, wobei die Adapterelemente durch eine Sollbruchstelle vom Träger trennbarsind. Dies gestattet mit Vorteil eine gemeinsame Handhabe von mehreren Adapterelementen. D. h. die einzelnen Adapterelemente müssen nicht jeweils einzeln transportiert bzw. für die Anbindung der Laserdioden vorbereitet werden. Beispielsweise lassen sich die mehreren Adapterelemente gemeinsam beschichten, wodurch die Fertigung der einzelnen Adapterelemente mit Vorteil vereinfacht wird. Vorzugsweise sind die Adapterelemente nebeneinander auf einem gemeinsamen Träger angeordnet und die benachbarten Adapterelemente sind durch entsprechende Sollbruchstellen voneinander getrennt.

Zweckmäßig ist es vorgesehen, dass das Adapterelement oder die Adapterelemente einen elektrisch leitenden Kontakt, insbesondere zu einem Träger des Verbunds, aufweisen. Die Anbindung über einen elektrischen Kontakt erweist sich insbesondere deshalb als vorteilhaft, weil mittels des elektrischen Kontakts das Adapterelement auf ein gewünschtes Potential für ein Sputterverfahren gehalten werden kann. Mit anderen Worten: Die Integration des elektrischen Kontakts ermöglicht es mit Vorteil, dass auf ein Einzelkontaktieren bei einem erforderlichen Beschichten des Adapterelements, insbesondere mit einem Lotmaterial, verzichtet werden kann. Dadurch wird die Anbindung der Laserdiode an den Kühlkörper weiter vereinfacht.

Besonders bevorzugt ist es vorgesehen, dass die erste Metallschicht und/oder die zweite Metallschicht eine Dicke zwischen 75 µm und 120 µm aufweist.

Vorzugsweise ist es vorgesehen, dass der elektrisch leitende Kontakt derart gestaltet ist, dass er beim Brechen der Sollbruchstelle abreißt. Insbesondere ist der elektrisch leitende Kontakt derart dünn gestaltet, dass er beim Aufwenden einer für das Abbrechen des Adapterelements entlang der Sollbruchstelle erforderlichen Kraft, abreißt. Vorstellbar ist auch, dass der elektrisch leitende Kontakt perforiert ist oder eine lokale Materialverdünnung aufweist. Durch die entsprechende Ausgestaltung des elektrisch leitenden Kontakts kann mit Vorteil auf einen zusätzlichen Arbeitsschritt verzichtet werden, in dem der elektrische leitende Kontakt entfernt werden muss.

Gemäß einer weiteren Ausführungsform der vorliegenden Erfindung ist es vorgesehen, dass die Zwischenschicht eine elektrisch leitende Durchkontaktierung, d. h. einen Via, aufweist bzw. aufweisen kann. Mittels einer Durchkontaktierung durch die andernfalls isolierend wirkende Zwischenschicht ist es mit Vorteil möglich, das Adapterelement auch für solche Anwendungsfälle zu nutzen, bei denen eine elektrische leitendende Verbindung zwischen der Laserdiode und dem Kühlkörper vorgesehen ist. Alternativ ist es vorstellbar, dass die Zwischenschicht isolierend für solche Anwendungsfälle, für die keine elektrische Verbindung zwischen der Laserdiode und dem Kühlkörper vorgesehen ist, ausgestaltet ist.

Die vorliegende Erfindung betrifft ein Verbund aus mehreren erfindungsgemäßen Adapterelementen, wobei die Adapterelemente erfindungsgemäß über eine Sollbruchstelle trennbar an einem gemeinsamen Träger angeordnet sind. Insbesondere erstreckt sich im Verbund eine gemeinsame Zwischenschicht, vorzugsweise keramische Zwischenschicht, sowohl über den Träger als auch über das Adapterelement, d. h die Adapterelemente und der Träger sind in einer parallel zu einer Haupterstreckungsebene (entlang derer sich die Zwischenschicht erstreckt) verlaufenden Ebene nebeneinander angeordnet. Vorzugsweise bilden die erste Metallschicht, die Zwischenschicht und die zweite Metallschicht den Träger und die Adapterelemente. Die Unterteilung zwischen Träger und Adapterelement ist durch eine Strukturierung in der ersten Metallschicht und der zweiten Metallschicht realisiert. Die Strukturierung lässt auch die sichtbare Trennung zwischen den einzelnen nebeneinander entlang einer Reihe angeordneten Adapterelementen erkennen. Insbesondere ist die Sollbruchstelle in der Keramikschicht, insbesondere in einem Bereich ohne erste und/oder zweite Metallschicht realisiert. Vorzugsweise verläuft die Sollbruchstelle sowohl zwischen den einzelnen in einer Reihe nebeneinander angeordneten Adapterelementen und zwischen dem Träger und den in einer Reihe angeordneten Adapterelementen. Zum Vereinzeln, d. h. zum Abbrechen der einzelnen Adapterelemente, muss vorzugsweise eine im Wesentlichen senkrecht zur ersten Metallschicht bzw. senkrecht zur Zwischenschicht, d. h. senkrecht zur Haupterstreckungsebene des Verbunds, verlaufende Kraft bzw. Brechkraft aufgewendet werden. Insbesondere ist es vorgesehen, dass durch die Strukturierung der ersten Metallschicht bzw. der zweiten Metallschicht, die Konturen bzw. Formen des Trägers und der Adapterelemente festgelegt werden.

Weiterhin ist es vorgesehen, dass sich der Träger im Wesentlichen parallel zu der Richtung längserstreckt, entlang die Adapterelemente nebeneinander in einer Reihe angeordnet sind, und die Adapterelemente stehen seitlich vom Träger ab. Die Adapterelemente und der Träger sind dabei kammähnlich ausgestaltet.

Erfindungsgemäß ist es vorgesehen, dass sich zwischen dem Träger und dem Adapterelement zumindest ein elektrisch leitender Kontakt erstreckt. Vorzugsweise sind mehrere, insbesondere zwei, elektrisch leitende Kontakte für ein einzelnes Adapterelement vorgesehen, die jeweils voneinander elektrisch isolierte Teilbereiche des ersten Metallschicht bzw. der zweiten Metallschicht mit dem Träger elektrisch leitend verbindet. Insbesondere reißt der elektrisch leitende Kontakt beim Trennen des jeweiligen Adapterelements vom Träger.

Vorzugsweise ist es vorgesehen, dass im Verbund der elektrisch leitende Kontakt eine Sollbruchstelle, insbesondere eine Sollbruchstelle zwischen den Adapterelementen und dem Träger, kreuzt. Insbesondere quert der elektrisch leitende Kontakt die Sollbruchstelle, vorzugsweise senkrecht. Dabei ist der elektrisch leitende Kontakt vorzugsweise stegförmig ausgestaltet und verbindet in der ersten Metallschicht bzw. der zweiten Metallschicht insbesondere den Bereich des Trägers mit dem Bereich des Adapterelements. Beim Brechen entlang der Sollbruchstelle wird dann der elektrisch leitende Kontakt abgerissen.

Vorzugsweise ist es vorgesehen, dass zur Vermeidung einer Materialanhäufung beim Brechen entlang einer Sollbruchstelle der Träger auf einer der Sollbruchstelle gegenüberliegenden Seite eine Aussparung, insbesondere in Form einer Nut, aufweist. Beispielsweise lässt sich die Nut mit einer Säge realisieren, insbesondere einer "Wafersäge". Alternativ oder ergänzend ist es auch vorstellbar, dass die Nut durch Laserablation oder Ätzen realisiert wird. Dabei ist die Nut vorzugsweise unterhalb der Sollbruchstelle angeordnet und erstreckt sich in lateraler Richtung, d. h. einer Richtung senkrecht zur Längserstreckung der Sollbruchstelle, weiter als eine für die Sollbruchstelle vorgesehene Einkerbung in der Zwischenschicht. Durch die Aussparung ist es in vorteilhafter Weise möglich, eine Materialanhäufung zu vermeiden, die andernfalls beim Brechen entlang der Sollbruchstelle auf der gegenüberliegenden Seite auftreten würden.

Ein weiterer Gegenstand der vorliegenden Erfindung ist ein Verfahren zur Herstellung eines erfindungsgemäßen Verbunds, wobei die erste Metallschicht und/oder die zweite Metallschicht mittels eines DCB -Verfahrens oder eines Aktivlotverfahrens an die Zwischenschicht angebunden werden. Alle für den erfindungsgemäßen Verbund beschriebenen Merkmale und deren Vorteile lassen sich sinngemäß ebenfalls auf das erfindungsgemäße Verfahren übertragen und andersherum.

Unter einem "DCB-Verfahren" (Direct-Copper-Bond-Technology) versteht der Fachmann ein solches Verfahren, das beispielsweise zum Verbinden von Metallisierungen oder -blechen (z. B. Kupferblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht) aus einer chemischen Verbindung aus dem Metall und einem reaktiven Gas, bevorzugt Sauerstoff, aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1065°C bis 1083°C, z. B. auf ca. 1071 °C;
- Abkühlen auf Raumtemperatur.

Unter einem Aktivlot-Verfahren, z. B. zum Verbinden von Metallisierungen oder Metallfolien, insbesondere auch von Kupferschichten oder Kupferfolien mit Keramikmaterial, ist ein Verfahren zu verstehen, welches speziell auch zum Herstellen von Metall-Keramik-Substraten verwendet wird. Hierbei wird bei einer Temperatur zwischen ca. 650 - 1000 °C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Vorzugsweise ist es vorgesehen, dass das Adapterelement mittels eines Sputterverfahrens beschichtet wird. Dadurch lässt sich das Adapterelement mit Vorteil mit einem Lotmaterial beschichten. Dieses Lotmaterial lässt sich dann zur Anbindung der Laserdiode an das Adapterelement nutzen. Vorzugsweise werden mehrere im Verbund angeordnete Adapterelemente in einem gemeinsamen Sputterprozess beschichtet. Insbesondere handelt es sich bei dem Sputterverfahren um ein PVD-Sputterdeposition -Verfahren.

Zweckmäßig ist es vorgesehen, dass das Adapterelement aus dem Verbund von Adapterelementen abgebrochen wird. Insbesondere ist es vorgesehen, dass das Adapterelement aus dem Verbund entfernt wird, nachdem die Laserdiode auf dem Adapterelement befestigt wurde, d. h. nach einem Beschichten des Adapterelements sowie Bestücken und Auflöten der Laserdiode auf das beschichtete Adapterelement.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:
- **Fig.1:**: ein montiertes Adapterelement,
- **Fig. 2:**: mehrere Adapterelemente gemäß einer zweiten bevorzugten Ausführungsform, wobei die Adapterelemente in einem Verband zusammengefasst sind,
- **Fig.3:**: ein Verbund aus mehreren Adapterelementen gemäß einer beispielhaften Ausführungsform der vorliegenden Erfindung in einer Draufsicht und
- **Fig.4:**: zwei Verbunde von mehreren Adapterelement gemäß weiterer beispielhafter Ausführungsform der vorliegenden Erfindung in Seitenansichten.

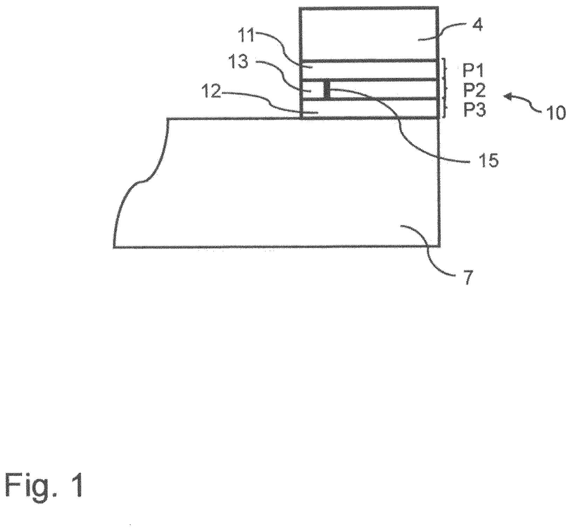

In **Figur 1** ist ein montiertes Adapterelement 10 gemäß einer ersten bevorzugten Ausführungsform dargestellt. Solch ein Adapterelement 10 ist dazu vorgesehen, als Bindeglied zwischen einem Kühlköper 7 und einem elektrischen Bauelement wie einer Laserdiode 4 zu dienen, wobei der Kühlkörper 7 zur Kühlung der im Betrieb wärmeentwickelnden Laserdiode 4 vorgesehen ist. Hierbei ist als Adapterelement 10 ein Verbundstruktur vorgesehen, wobei das Adapterelement 10 insbesondere eine erste Metallschicht 11, die im montierten Zustand dem Kühlkörper 7 zugewandt ist, und eine zweite Metallschicht 12, die im montierten Zustand der Laserdiode 4 zugewandt ist, aufweist. Vorzugsweise umfasst die erste Metallschicht 11 und/oder zweite Metallschicht 12 Kupfer. Zwischen der ersten Metallschicht 11 und der zweiten Metallschicht 12 ist weiterhin eine Zwischenschicht 13 angeordnet, wobei die Zwischenschicht 13 eine Keramik aufweist. Um eine möglichst homogene Wärmeverteilung in einem Schnittstellenbereich zwischen dem Adapterelement 10 und dem Kühlkörper 7 zu erzielen, ist es vorgesehen, dass die erste Metallschicht 11 und/oder die zweite Metallschicht 12 eine Primärdicke P1 aufweist, wobei die Primärdicke P1 größer als 40 µm, bevorzugt größer als 70 µm und besonders bevorzugt größer als 100 µm ist. Hierbei hat sich insbesondere herausgestellt, dass sich derart dicke Metallschichten mittels eines DCB-Verfahrens oder eines Aktivlot-Verfahrens vergleichsweise einfach und insbesondere schnell realisieren lassen.

Durch eine derart dicke Metallschicht ist eine Wärmespreizung, d. h. eine Aufweitung einer andernfalls lokal konzentrierten Wärmentwicklung, beim Wärmeabtransport von der Laserdiode 4 über das Adapterelement 10 möglich. Weiterhin ist es besonders bevorzugt vorgesehen, dass die die Keramik umfassende Zwischenschicht 13 eine Sekundärdicke P2 aufweist, die kleiner als 400 µm, kleiner als 200 µm und besonders bevorzugt größer als 200 µm ist. Mittels einer solch dicken Zwischenschicht 13 lässt sich mit Vorteil eine CTE-Anpassung erzielen, die insbesondere zusammen mit der Wärmespreizung zu einem möglichst spannungsfreien Übergang zwischen dem Adapterelement 10 und dem Kühlkörper 4 führt. D. h. im Betrieb der Laserdiode 4, die verantwortlich für eine Wärmeentwicklung ist, wird durch die entsprechende Anpassung der Primärdicke P1 und/oder Sekundärdicke P2 eine Ausbildung einer thermomechanischen Spannung unterdrückt bzw. geschwächt. Dadurch lässt sich eine Wahrscheinlichkeit für eine Rissbildung bzw. eine Deformation der Laserdiode 4 reduzieren. Zur weiteren Verbesserung der Leitfähigkeit ist vorzugsweise eine Zwischenschicht 13 mit einer Wärmeleitfähigkeit von mehr als 150 W/mK, bevorzugt mehr als 175 W/mK und besonderes bevorzugt von mehr als 225 W/mK vorgesehen.

Weiterhin ist es vorstellbar, dass die Primärdicke P1 der ersten Metallschicht 11 sich von der der Primärdicke P1 der zweiten Metallschicht 12 unterscheidet oder im Wesentlichen gleich groß ist. Denkbar ist ferner, dass ein Verhältnis zwischen einer aufsummierten Dicke der Primärdicken P1 der ersten Metallschicht 11 und der zweiten Metallschicht 12 zur Sekundärdicke P2 ein Verhältnis zwischen 0,7 und 2, bevorzugt zwischen 0,8 und 1,5 und besonders bevorzugt zwischen 0,95 und 1,2 annimmt.

Weiterhin ist es bevorzugt vorgesehen, dass die Zwischenschicht 13 eine Durchkontaktierung 15 aufweist. Eine solche Durchkontaktierung 15 erlaubt eine Nutzung des Adapterelements 10 bei solchen Anwendungsfällen, in denen eine nichtisolierende Anbindung der Laserdiode 4 an den Kühlkörper 7 erwünscht ist.

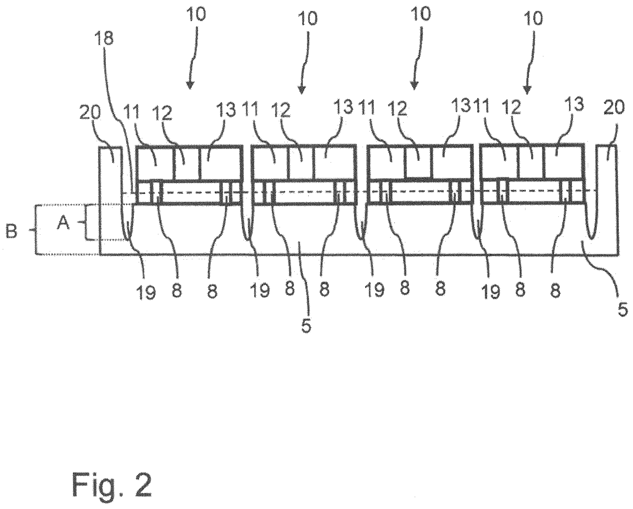

In der **Figur 2** sind mehrere Adapterelemente 10 gemäß einer zweiten bevorzugten Ausführungsform dargestellt, wobei die Adapterelemente 10 in einem Verband 1 zusammengefasst sind. Ein solcher Verbund 1, d. h. Multiframe, wird insbesondere demjenigen bereitgestellt, der die Laserdiode 4 über das Adapterelement 1 an den Kühlkörper 7 montieren möchte. Durch die Anordnung im Verbund 1 können mit Vorteil mehrere Adapterelemente 10 simultan für den anschließenden Anbindungsprozess der Laserdiode 4 vorbereitet werden. Beispielsweise werden die Adapterelement 10 zur Vorbereitung vor der Anbindung der Laserdiode 4 am Adapterelement 10 mittels eines Sputterverfahrens beschichtet. Um eine für das Sputterverfahren erforderliche elektrische Kontaktierung der Adapterelemente 10 sicherzustellen, sind für jedes Adapterelement 10 elektrisch leitenden Kontakte 8, d. h. Beschichtungskontakte, vorgesehen. Insbesondere verbinden diese elektrisch leitenden Kontakte 8 das jeweilige Adapterelement 10 mit einem Träger 5, auf dem die Adapterelementen 10 angeordnet sind. Vorzugsweise werden die erste Metallsicht und/oder die zweite Metallschicht jeweils über einen leitenden Kontakt mit dem Träger verbunden. Durch die bereits in den Verbund 1 integrierten Kontakte 8 kann mit Vorteil auf eine Einzelkontaktierung der einzelnen Adapterelemente 10 verzichtet werden. Ferner ist es vorgesehen, dass die elektrisch leitenden Kontakte 8 derart dimensioniert sind, dass sie beim Entfernen des Adapterelements 10 vom Verbund 1 bzw. vom Träger 5 abreißen. Dadurch kann bei der Fertigung auf einen zusätzlichen Arbeitsschritt verzichtet werden, mit dem der elektrisch leitende Kontakt 8 wieder entfernt werden müsste. Vorzugsweise sind im Verbund Sollbruchstellen 18 vorgesehen, entlang der die Adapterelemente 10 abgebrochen werden, wenn das Beschichtungsverfahren, insbesondere das Sputterverfahren, beendet ist und das Adapterelement 10 vom Verbund 1 getrennt wird. Vorzugsweise wird die Sollbruchstelle 18 durch eine Laserbehandlung realisiert, z.B. durch eine Laserritzlinie in der Keramik der Zwischenschicht, die die elektrisch leitenden Kontakten kreuzt. Ferner sind zwischen den Adapterelementen 10 Sägespalte 19 vorgesehen, die bis in den Träger 5 reichen. Entlang dieser Sägespalte 19 lassen sich die einzelnen Adapterelemente 19 voneinander trennen, um anschließend zur Anbindung der Laserdiode 4 auf dem Kühlkörper 7 zu dienen. Vorzugsweise beträgt das Verhältnis einer Tiefe A des Sägespalt 19 in den Träger 5 zur Dicke B des Trägers 5 im Bereich der Adapterelement 10 einen Wert zwischen 0,6 und 0,9, bevorzugt zwischen 0,75 und 0,85 und besonders bevorzugt im Wesentlichen 0,8. Dadurch lässt sich ein einfaches Trennen der Adapterelemente 10 realisieren und gleichzeitig wird eine ausreichende Stabilität gewährleistet, die die Adapterelemente 10 während des Sputterverfahrens zusammenhält. Weiterhin ist es vorgesehen, dass der Träger 5 ein Rahmenelement 20 aufweist, das sich seitlich an die Folge von nebeneinander aufgereihten Adapterelementen 10 anschließt und zu einer Seite hin bündig mit den Adapterelementen 10 abschließt. Dadurch werden die Adapterelemente 10 zur Seite hin von den Rahmenelementen 20 geschützt.

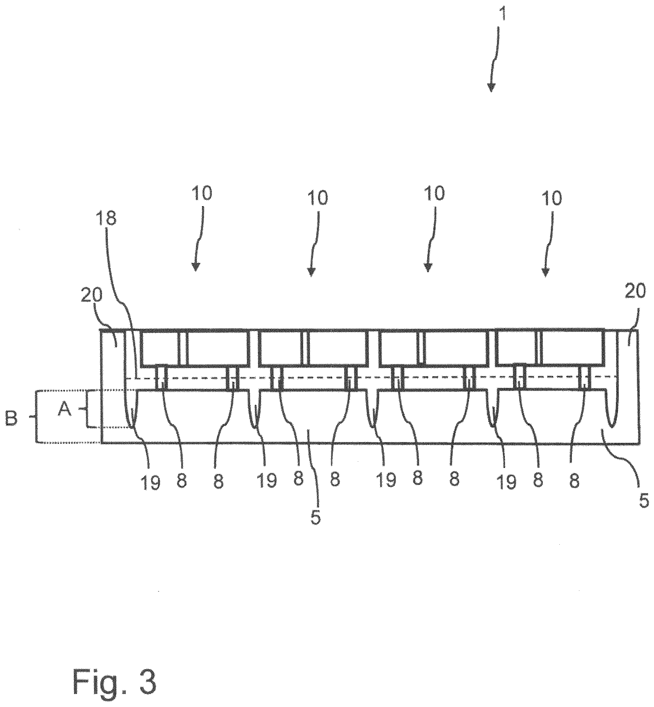

In **Figur 3** ist ein Verbund 1 aus mehreren Adapterelementen 10 gemäß einer beispielhaften Ausführungsform der vorliegenden Erfindung dargestellt. Insbesondere handelt es sich um eine Draufsicht auf den Verbund 1, in dem mehrere Adapterelemente 10 nebeneinander entlang einer Reihe angeordnet sind. Insbesondere erfolgt der Blick auf den Verbund 1 entlang einer Richtung, die parallel zu einer Stapelrichtung verläuft, entlang der die erste Metallschicht 11, die Zwischenschicht 13 und die zweite Metallschicht 12 übereinander geordnet sind, d. h. in Figur 3 ist die strukturierte erste Metallschicht 11 bzw. die zweite Metallschicht 12 zu sehen, wobei die Strukturierungen der ersten Metallschicht 11 bzw. der zweiten Metallschicht 12 unteranderem die Zuordnung der jeweiligen Abschnitte zum Adapterelement 10 bzw. zum Träger 5 festlegt. In den Bereichen, die in Folge der Strukturierung der ersten Metallschicht 11 bzw. der zweiten Metallschicht 12 freiliegen, d. h. ohne Metall sind, ist in der Draufsicht die Zwischenschicht 13 zu erkennen. Vorzugsweise verlaufen in diesen metallfreien Bereichen die Sollbruchstellen 18, entlang derer die Adapterelemente 10 untereinander bzw. vom Träger 5 getrennt werden können. Weiterhin ist es vorgesehen, dass das Adapterelement 10, insbesondere der Verbund 1, mehrere elektrisch leitende Kontakte 8 aufweist, die den Träger 5 mit dem Adapterelement 10 oder verschiedenen Teilen der ersten Metallschicht 11 bzw. der zweiten Metallschicht 12 des Adapterelement 10 verbindet, insbesondere jeweils verbindet.

Weiterhin ist es bevorzugt vorgesehen, dass die erste Metallschicht 11 oder die zweite Metallschicht 12 auf dem Verbund 1 derart strukturiert ist, dass ein elektrisch leitender Kontakt 8 zwischen der ersten Metallschicht 11 bzw. zweiten Metallschicht 12 im Bereich des Trägers 5 und der ersten Metallschicht 11 bzw. der zweiten Metallschicht 12 im Bereich des einzelnen Adapterelements 10 ausgebildet wird. Vorzugsweise ist der elektrisch leitende Kontakt 8 stegförmig ausgestaltet. Dabei verläuft der stegförmige, elektrisch leitende Kontakt 8 vorzugsweise senkrecht zum Verlauf der Sollbruchstelle 18, entlang der die Adapterelemente 10 vom Träger 5 getrennt werden. Insbesondere quert der elektrisch leitende Kontakt 5 die Sollbruchstelle 18. Es ist auch vorstellbar, dass der stegförmige, elektrisch leitende Kontakt 8 in einem Winkel zwischen 30° und 90°, bevorzugt zwischen 45° und 85° und besonders bevorzugt zwischen 60° und 80° geneigt ist gegenüber einer Längserstreckung der Sollbruchstelle 18.

Weiterhin ist es vorgesehen, dass voneinander elektrisch isolierte Teilbereiche der ersten Metallschicht 11 bzw. zweiten Metallschicht 12 jeweils mit einem eigenen elektrisch leitenden Kontakt 8 mit dem Träger 5 verbunden sind, insbesondere mit der ersten Metallschicht 11 bzw. zweiten Metallschicht 12 des Trägers 5. Weiterhin ist es vorgesehen, dass entlang einer Richtung, die durch die Längserstreckung der Sollbruchstelle 18 zwischen den Adapterelementen 10 und dem Träger 5 festgelegt wird, eine Breite des stegartigen elektrisch leitenden Kontakts 8 schmaler ist als ein 0,1-faches, bevorzugt weniger als 0,05-faches und besonders bevorzugt weniger als 0,01-faches der in derselben Richtung bemessenen Breite des Adapterelements 10.

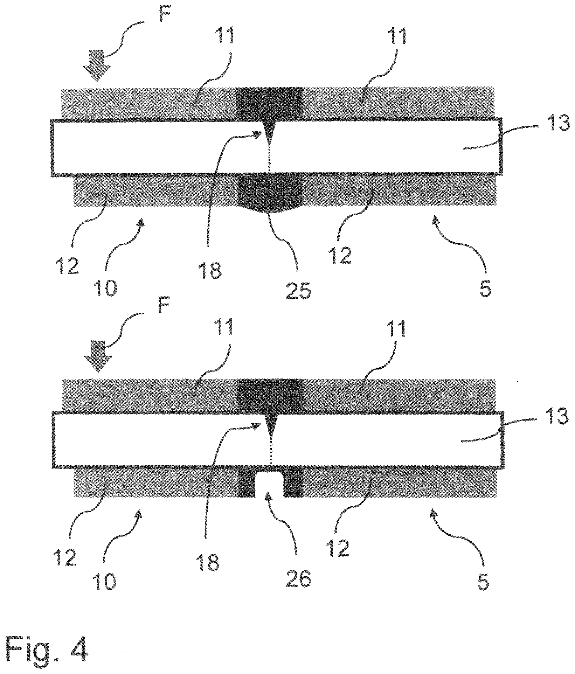

In **Figur 4** sind zwei Schnittansichten durch den Verbund 1 aus Figur 3 dargestellt. Insbesondere zeigt die obere Schnittansicht einen Verbund 1 vor dem Vereinzeln der Adapterelemente 10. Beim Abbrechen wird hier mit einer Kraft F auf den Verbund 1 eingewirkt. In Folge des Bruchs kommt es auf der die Krafteinwirkung erfahrenden Seite gegenüberliegenden Seite des Verbunds 1 zu einer Materialanhäufung unterhalb der Sollbruchstelle 18. Diese Materialanhäufung bildet einen wulstartige Vorsprung 25 an der Außenseite des Verbunds 1 aus. Um eine solche ungewünschte Materialanhäufung mit einer entsprechenden Vorsprungsbildung entgegenzuwirken, ist es vorzugsweise vorgesehen, dass auf der der Sollbruchstelle 18 gegenüberliegenden Seite, beispielsweise mittels einer Säge, insbesondere einer "Wafersäge", mittels Ätzen oder mittels eines spanenden Vorgang, insbesondere eines Fräsens, eine Nut 26 in den Verbund 1 einzulassen. Insbesondere verläuft die Nut 25 in Stapelrichtung gesehen unterhalb der Sollbruchstelle 18, wobei die Sollbruchstelle besonders bevorzugt keilförmig in die Zwischenschicht 13 eingelassen ist. Vorzugsweise ist eine laterale Ausdehnung der Nut 26 breiter als eine laterale Ausdehnung des als Sollbruchstelle 18 dienenden Spalts.

### Bezugszeichenliste:

- 1: Verbund
- 4: Laserdiode
- 5: Träger
- 7: Kühlkörper
- 8: Kontakt
- 10: Adapterelement
- 11: erste Metallschicht
- 12: zweite Metallschicht
- 13: Zwischenschicht
- 15: Durchkontaktierung
- 18: Sollbruchstelle
- 19: Sägespalt
- 20: Rahmenelement
- 25: Vorsprung
- 26: Nut
- A: Tiefe
- B: Dicke
- F: Kraft

## Patentansprüche

1. Verbund (1) aus mehreren Adapterelementen (10), die zum Anbinden eines Bauelements wie einer Laserdiode (4) an einen Kühlkörper (7) geeignet sind, umfassend
-- eine erste Metallschicht (11), die im montierten Zustand dem Bauelement (4) zugewandt ist, und eine zweite Metallschicht (12), die im montierten Zustand dem Kühlkörper (7) zugewandt ist, und weiter **gekennzeichnet durch**
-- eine zwischen der ersten Metallschicht (11) und der zweiten Metallschicht (12) angeordnete, Keramik umfassende Zwischenschicht (13),
wobei die ersten Metallschicht (11) und/oder die zweite Metallschicht (12) dicker als 40 µm, bevorzugt dicker als 70 µm und besonders bevorzugt dicker als 100 µm ist, wobei die Adapterelemente (10) durch eine Sollbruchstelle (18) von einem Träger (5) trennbar sind, und die Adapterelemente (10) einen elektrisch leitenden Kontakt (8) zum Träger (5) des Verbunds (1) aufweisen.

2. Verbund (1) gemäß Anspruch 1, wobei die Zwischenschicht (13) zur Anpassung der Ausdehnungskoeffizienten dünner als 400 µm, bevorzugt dünner als 200 µm und besonders bevorzugt dünner als 100 µm ist.

3. Verbund (1) gemäß einem der vorhergehenden Ansprüche, wobei ein Verhältnis zwischen einer aufsummierten Dicke einer Primärschichtdicke der ersten Metallschicht (11) und einer Primärschichtdicke der zweiten Metallschicht (12) zur Sekundärschichtdicke der Zwischenschicht (13) einen Wert zwischen 0,2 und 0,8, bevorzugt zwischen 0,25 und 0,65 und besonders bevorzugt zwischen 0,3 und 0,55 annimmt.

4. Verbund (1) gemäß einem der vorhergehenden Ansprüche, wobei der elektrisch leitende Kontakt (8) derart gestaltet ist, dass er beim Brechen der Sollbruchstelle abreißt.

5. Verbund (1) gemäß einem der vorhergehenden Ansprüche, wobei die Zwischenschicht (13) eine elektrisch leitende Durchkontaktierung (15) aufweisen kann.

6. Verbund (1) gemäß Anspruch 5, wobei sich zwischen dem Träger (5) und dem Adapterelement (10) zumindest ein stegförmiger, elektrisch leitender Kontakt (8) erstreckt.

7. Verbund (1) gemäß einem der vorhergehenden Ansprüche, wobei der elektrisch leitende Kontakt (8) eine Sollbruchstelle (18), insbesondere eine Sollbruchstelle (18) zwischen den Adapterelementen (10) und dem Träger (5), kreuzt.

8. Verbund (1) gemäß einem der vorhergehenden Ansprüche, wobei zur Vermeidung einer Materialanhäufung beim Brechen entlang einer Sollbruchstelle (18) der Träger (5) auf einer der Sollbruchstelle (18) gegenüberliegenden Seite eine Aussparung, insbesondere in Form einer Nut (26), aufweist.

9. Verfahren zur Herstellung eines Verbunds gemäß einem der Ansprüche 1 bis 8, wobei die erste Metallschicht (11) und/oder die zweite Metallschicht (12) mittels eines DCB - Verfahrens oder eines Aktivlotverfahrens an die Zwischenschicht (13) angebunden werden.

10. Verfahren gemäß Anspruch 9, wobei das Adapterelement (10) mittels eines Sputterverfahrens beschichtet wird.

11. Verfahren gemäß Anspruch 9 oder 10, wobei das Adapterelement (10) aus dem Verbund (1) von Adapterelementen (10) abgebrochen wird.

## Claims

1. A composite (1) of a plurality of adapter elements (10) suitable for connecting a device such as a laser diode (4) to a heat sink (7), comprising
- a first metal layer (11), which, in the mounted state, faces the component (4), and a second metal layer (12), which, in the mounted state, faces the heat sink (7), and further **characterized by**
- an intermediate layer (13) which is arranged between the first metal layer (11) and the second metal layer (12) and comprises ceramics, the first metal layer (11) and/or the second metal layer (12) being thicker than 40 µm, preferably thicker than 70 µm and particularly preferably thicker than 100 µm, wherein it is possible to separate the adapter elements (10) from a support (5) using a predetermined breaking point (18), and the adapter elements (10) comprising an electrically conductive contact (8) to the support (5) of the composite (1).

2. The composite (1) according to claim 1, wherein the intermediate layer (13) is thinner than 400 µm, preferably thinner than 200 µm and particularly preferably thinner than 100 µm to matching the coefficients of expansion.

3. The composite (1) according to one of the preceding claims, wherein a ratio between an added up thickness of a primary layer thickness of the first metal layer (11) and a primary layer thickness of the second metal layer (12) to the secondary layer thickness of the intermediate layer (13) assumes a value between 0.2 and 0.8, preferably between 0.25 and 0.65 and particularly preferably between 0.3 and 0.55.

4. The composite (1) according to one of the preceding claims, wherein the electrically conductive contact (8) is configured such that it tears off when the predetermined breaking point is broken.

5. The composite (1) according to one of the preceding claims, wherein the intermediate layer (13) may have an electrically conductive via (15).

6. The composite (1) according to claim 5, wherein at least one web-shaped electrically conductive contact (8) extends between the support (5) and the adapter element (10).

7. The composite (1) according to one of the preceding claims, wherein the electrically conductive contact (8) crosses a predetermined breaking point (18), especially a predetermined breaking point (18) between the adapter elements (10) and the support (5).

8. The composite (1) according to one of the preceding claims, wherein the support (5) has a recess, especially in the form of a groove (26), on a side opposite the predetermined breaking point (18) to avoid material accumulation when breaking along a predetermined breaking point (18).

9. A method for the production of a composite according to any one of claims 1 to 8, wherein the first metal layer (11) and/or the second metal layer (12) are attached to the intermediate layer (13) using a DCB process or an active soldering process.

10. The process according to claim 9, wherein the adapter element (10) is coated using a sputtering process.

11. The method according to claim 9 or 10, wherein the adapter element (10) is broken away from the composite (1) of adapter elements (10).

## Revendications

1. Composite (1) de plusieurs éléments adaptateurs (10) aptes à attacher un composant, tel qu'une diode laser (4), à un dissipateur thermique (7), comprenant
- une première couche métallique (11) qui, à l'état monté, est tournée vers le composant (4), et une deuxième couche métallique (12) qui, à l'état monté, est tournée vers le dissipateur thermique (7),
**caractérisé par**
- une couche intermédiaire (13) comprenant une céramique, disposée entre la première couche métallique (11) et la deuxième couche métallique (12), la première couche métallique (11) et/ou la deuxième couche métallique (12) étant d'une épaisseur supérieure à 40 µm, de préférence supérieure à 70 µm et de manière particulièrement préférée supérieure à 100 µm, les éléments adaptateurs (10) pouvant être séparés d'un support (5) par un emplacement destiné à la rupture (18), et
les éléments adaptateurs (10) présentant un contact électriquement conducteur (8) vers le support (5) du composite (1).

2. Composite (1) selon la revendication 1, dans lequel, pour adapter les coefficients de dilatation, la couche intermédiaire (13) est d'une épaisseur inférieure à 400 µm, de préférence inférieure à 200 µm et de manière particulièrement préférée inférieure à 100 µm.

3. Composite (1) selon l'une des revendications précédentes, dans lequel un rapport entre une épaisseur additionnée, formée d'une épaisseur de couche primaire de la première couche métallique (11) et d'une épaisseur de couche primaire de la deuxième couche métallique (12), sur l'épaisseur de couche secondaire de la couche intermédiaire (13) prend une valeur comprise entre 0,2 et 0,8, de préférence entre 0,25 et 0,65 et de manière particulièrement préférée entre 0,3 et 0,55.

4. Composite (1) selon l'une des revendications précédentes, dans lequel le contact électriquement conducteur (8) est conçu de manière à se rompre lors de la rupture de l'emplacement destiné à la rupture.

5. Composite (1) selon l'une des revendications précédentes, dans lequel la couche intermédiaire (13) peut présenter un via (15) électriquement conducteur.

6. Composite (1) selon la revendication 5, dans lequel au moins un contact électriquement conducteur (8) en forme de barrette s'étend entre le support (5) et l'élément adaptateur (10).

7. Composite (1) selon l'une des revendications précédentes, dans lequel le contact électriquement conducteur (8) croise un emplacement destiné à la rupture (18), en particulier un emplacement destiné à la rupture (18) entre les éléments adaptateurs (10) et le support (5).

8. Composite (11) selon l'une des revendications précédentes, dans lequel, pour éviter une accumulation de matière lors de la rupture le long d'un emplacement destiné à la rupture (18), le support (5) présente un évidement, en particulier sous forme de rainure (26), sur un côté opposé à l'emplacement destiné à la rupture (18).

9. Procédé de fabrication d'un composite selon l'une des revendications 1 à 8, dans lequel la première couche métallique (11) et/ou la deuxième couche métallique (12) sont attachées à la couche intermédiaire (13) au moyen d'un procédé DCB (Direct Copper Bonding) ou d'un procédé de brasage actif.

10. Procédé selon la revendication 9, dans lequel l'élément adaptateur (10) est revêtu au moyen d'un procédé de pulvérisation cathodique.

11. Procédé selon la revendication 9 ou 10, dans lequel l'élément adaptateur (10) est enlevé par rupture du composite (1) d'éléments adaptateurs (10).
